# EUROPÄISCHE PATENTSCHRIFT

(11) **EP 1 807 876 B1**
(45) Veröffentlichungstag und Bekanntmachung des Hinweises auf die Patenterteilung: **02.04.2008**
(21) Anmeldenummer: 05806928.7
(22) Anmeldetag: 03.11.2005
(51) Int. Cl.: H01L 31/105, H01L 27/146

(54) **VERTIKALE PIN ODER NIP FOTODIODE UND VERFAHREN ZUR HERSTELLUNG, KOMPATIBEL ZU EINEM KONVENTIONELLEN CMOS-PROZESS**
VERTICAL PIN OR NIP PHOTODIODE AND METHOD FOR THE PRODUCTION THEREOF WHICH IS COMPATIBLE WITH A CONVENTIONAL CMOS-PROCESS
PHOTODIODE PIN OU NIP VERTICALE ET PROCEDE DE REALISATION COMPATIBLE AVEC UN PROCESSUS CMOS CONVENTIONNEL

(30) Priorität: 03.11.2004 DE 102004053077
(43) Veröffentlichungstag der Anmeldung: 18.07.2007
(73) Patentinhaber: X-FAB Semiconductor Foundries AG, 99097 Erfurt (DE)
(72) Erfinder: BACH, Konrad, 99189 Tiefthal (DE); EINBRODT, Wolfgang, 99099 Erfurt (DE)
(74) Vertreter: Leonhard, Frank Reimund
(86) Internationale Anmeldenummer: PCT/DE2005/001969
(87) Internationale Veröffentlichungsnummer: WO 2006/048001

(56) Entgegenhaltungen:
- EP-A- 1 109 229
- DE-A1- 10 252 878
- US-A- 5 355 013
- US-A- 6 150 676
- US-B1- 6 218 691
- ESPINASSE P B ET AL: "WHAT'S IN STORE FOR SILICON PHOTORECEIVERS?" IEEE CIRCUITS AND DEVICES MAGAZINE, IEEE SERVICE CENTER, PISCATAWAY, NJ, US, Bd. 20, Nr. 2, März 2004 (2004-03), Seiten 23-31, XP001192984 ISSN: 8755-3996

## Beschreibung

Die Erfindung betrifft die Herstellung einer schnell arbeitenden integrierten CMOS kompatiblen Fotodiode und diese selbst.

Es ist üblich, die CMOS-inhärenten Dioden auch zur Umwandlung optischer Signale einzusetzen. Ohne spezifische Optimierung werden für viele Aufgaben befriedigende Ergebnisse erzielt.

Eine Reihe von speziellen Konstruktionen solcher Dioden sind für die Nutzung in Bildsensorschaltkreisen in der Patentliteratur beschrieben. Durch speziell eingebrachte Implantationen wurde das Signal-Rauschverhältnis verbessert, z.B. US-A 6,514,785**,** TW-A 441 117 und GB-A 2 367 945**.**

Unter dem gleichen Aspekt ist auch die Erhöhung des Füllfaktors zu sehen, die in der EP-A 1 109 229 gezeigt ist.

Andere Zielrichtungen sind die Reduzierung des Dunkelstromes und die Verbesserung der spektralen Empfindlichkeit, vgl. US-A 6,320,617**.**

Das Dokument US-A-6 150 676 beschreibt eine integrierte Photodiode auf eine Substrat.

In CMOS-Techriologie hergestellte Fotodioden haben aber im allgemeinen den Nachteil, dass bedingt durch das tiefe Eindringen des Lichtes auch nach einigen 100ns noch Ladungsträger detektiert werden, die eine Begrenzung der Bandbreite auf etwa 10MHz darstellen. Es sind differentielle Lösungen beschrieben, mit deren Hilfe der langsame Signalteil abgeschnitten wird, was allerdings auf Kosten der Empfindlichkeit geht.

Der Erfindung liegt die technische Aufgabe zugrunde, diese geschilderten Nachteile hinsichtlich des erweiterten Frequenzbereiches zu überwinden, also auch eine schnelle Photodiode zu schaffen.

Gemäß einem Aspekt der vorliegenden Erfindung wird die Aufgabe gelöst durch eine integrierte schnelle Photodiode, wie in Anspruch 1 beschrieben.

Durch diesen Aufbau, der einer PIN- bzw. einer NIP-Konfiguration entspricht, lässt sich eine effiziente Photodiode in CMOS-kompatibler Weise herstellen, da insbesondere das Vorsehen des niedrig dotierten I-Gebiets zwischen dem stark dotierten Substrat und dem Wannen- bzw. Drain- und Sourcegebiet mit Prozessen für herkömmliche CMOS-Bauelemente vonstatten gehen kann, ohne dass im Wesentlichen eine Beeinträchtigung der weiteren CMOS-Bauelemente erfolgt. Des Weiteren ist durch diese Anordnung ein gegenüber konventionellen Photodioden erhöhtes elektrisches Feld auch innerhalb des I-Gebiets vorhanden, so dass durch Lichteinfall erzeugte Ladungsträger rasch abfließen können.

In einer weiteren vorteilhaften Ausführungsform weist das niedrig dotierte I-Gebiet eine Dotierungskonzentration von kleiner 1*10¹⁴ cm⁻³ auf. Diese geringe Dotierung unterstützt den geeigneten Feldverlauf innerhalb der PIN- bzw. NIP-Struktur, so dass das schnelle Antwortverhalten bei Lichteinfall gewährleistet ist.

Hierdurch wird im Zusammenhang mit der äußerst geringen Dotierstoffkonzentration der gewünschte Feldverlauf und damit das gewünschte Ansprechverhalten in sehr effizienter Weise erreicht.

In einer weiteren Ausführungsform liegt das Elektrodengebiet voll umschlossen in dem niedrig dotierten I-Gebiet. Daraus ergibt sich ein effizientes Verhalten bei der Ladungsträgersammlung.

In einer weiteren vorteilhaften Ausführungsform beträgt der Abstand vom Rand des Elektrodengebiets zu einem benachbarten, höher dotiertem Gebiet 2,5 bis 10µm, insbesondere als ein benachbartes Wannengebiet. Auf diese Weise ist eine zuverlässige Abgrenzung zu benachbarten CMOS-Bauteilen gegeben, so dass im Wesentlichen keinerlei gegenseitige Störungen auftreten.

In einer weiteren Ausführungsform ist das Substrat p-dotiert und besitzt einen spezifischen elektrischen Widerstand von kleiner als 0,05 Ohm*cm. Somit kann das gewünschte Leitverhalten des als Anode dienenden Substrats in effizienter Weise bereitgestellt werden.

In einer weiteren Ausführungsform ist das Substrat n-dotiert. Damit ergibt sich eine NIP-Struktur für die schnelle Photodiode. Damit können in effizienter Weise entsprechende Photodiodenstrukturen eingerichtet werden, so dass sich insgesamt eine hohe Flexibilität beim Entwerfen komplexer CMOS-Schaltungen ergibt.

In einer weiteren vorteilhaften Ausführungsform entspricht die Dotierung des Elektrodengebiets in/nach Typ, Höhe und Verlauf der Dotierung des Wannengebiets. Somit lässt sich das Elektrodengebiet in kompatibler Weise bei der Herstellung weiterer CMOS-Bauelemente erzeugen.

In einer weiteren vorteilhaften Ausführungsform entspricht die Dotierung des Elektrodengebiets in Typ, Höhe und Verlauf der Dotierung von Drain und Source (-gebiet) eines in dem Substrat hergestellten CMOS-Bauelements. Somit kann insbesondere eine sehr hohe Dotierstoffkonzentration erreicht werden, ohne dass eine Änderung der Fertigungssequenz für die anderen CMOS-Bauelemente erforderlich ist.

In einer weiteren vorteilhaften Ausführungsform ist das I-Gebiet als Epitaxieschicht vorgesehen. Auf diese Weise lässt sich in effizienter Weise das gering dotierte I-Gebiet herstellen, ohne dass die weitere Fertigung der CMOS-Bauelemente beeinträchtigt wird, da das epitaktische Aufwachsen des I-Gebiets stattfinden kann, bevor temperaturempfindliche Prozesse in der CMOS-Herstellung stattfinden.

In einer weiteren Ausführungsform ist die Dicke des I-Gebiets in Abhängigkeit von der Wellenlänge bestimmt. Die Schichtdicke des beispielsweise epitaktisch aufgewachsenen I-Gebiets kann durch Steuerung des Wachstumsprozesses auf eine gewünschte Detektions-Wellenlänge optimal eingestellt werden.

In einer weiteren vorteilhaften Ausführungsform ist die Photodiode als Detektor mit Auswerteschaltungen integriert. Da insbesondere die Fertigung der schnellen Photodiode in CMOS-kompatibler Weise erfolgt, können komplexe Auswerteschaltungen unmittelbar zusammen mit der oder den Photodiode(n) verwirklicht werden.

In einer weiteren Ausführungsform ist die schnelle Photodiode als Detektor mit Transimpedanz-Verstärkern in Auswerteschaltungen integriert. Somit lässt sich ein sehr effizienter Detektor herstellen, wobei entsprechende Eingangsverstärker unmittelbar mit der gleichen Prozesstechnologie herstellbar sind, so dass sich insbesondere eine sehr verlustarme und schnell reagierende Anordnung verwirklichen lässt.

In einer weiteren Ausführungsform ist die schnelle Photodiode mit mehreren weiteren schnellen Photodioden gleicher Bauart und Auswerteschaltungen für mehrere Kanäle integriert. Auf diese Weise lässt sich eine entsprechende Auswerteschaltung selbst für komplexe Aufgaben mit mehreren auszuwertenden Signalen verwirklichen.

Gemäß einem weiteren Aspekt wird die Aufgabe gelöst durch eine integrierte schnelle PIN-Photodiode, die mit CMOS-Technologie hergestellt oder durch diese herstellbar ist, wobei diese aus einer dem hochdotierten p-Substrat mit einem spezifischen elektrischen Widerstand von kleiner 0.05 Ohm.cm entsprechenden Anode besteht und ferner ein sich anschließendes p-dotiertes I-Gebiet und eine in der Dotierung den n⁺-dotierten Bereichen des Source und Drain entsprechende n-Kathode vorgesehen sind. Dabei besitzt das niedrig dotierte I-Gebiet eine Dotierungskonzentration von kleiner 10¹⁴ cm⁻³ und eine Dicke zwischen 8 und 25µm, wobei das Kathodengebiet voll umschlossen in diesem sehr niedrig dotierten I-Gebiet liegt und wobei der Abstand vom Rand des Kathodengebiets zu einem höher dotierten benachbarten Gebiet, insbesondere als benachbartes Wannengebiet, zwischen 2,5 und 10µm beträgt.

Wie zuvor dargelegt ist, ergibt sich auf Grund dieser Anordnung eine sehr effiziente PIN-Photodiode, wobei insbesondere die Kathode zusammen mit den entsprechenden Drain- und Sourcegebieten anderer CMOS-Bauelemente hergestellt werden kann.

Gemäß einem weiteren Aspekt wird die Aufgabe durch eine integrierte schnelle PIN-Photodiode gelöst, die mit CMOS-Technologie hergestellt ist oder herstellbar ist, und wobei diese aus einem hoch dotiertem p-Substrat mit einem spezifischen elektrischen Widerstand von kleiner 0,05 Ohm.cm besteht, die der Anode entspricht, und wobei ein sich anschließendes niedrig p-dotiertes I-Gebiet und eine in der Dotierung dem n-Wannengebiet entsprechende n-Kathode vorgesehen ist. Dabei weist das niedrig dotierte I-Gebiet eine Dotierungskonzentration von kleiner 1x10¹⁴ cm⁻³ und eine Dicke zwischen 8 und 25 µm auf, wobei das Kathodengebiet voll umschlossen in dem sehr niedrig dotierten I-Gebiet liegt und wobei der Abstand vom Rand des Kathodengebiets zu einem höher dotierten benachbarten Gebiet, das in einer weiteren Ausführungsform ein benachbartes Wannengebiet repräsentiert, zwischen 2,5 und 10µm beträgt.

Somit kann insbesondere das Kathodengebiet in Verbindung mit der Implantation entsprechender Wannengebiete in CMOS-kompatibler Weise hergestellt werden.

Gemäß einem weiteren Aspekt wird die Aufgabe gelöst durch ein Verfahren zur Herstellung einer integrierten schnellen Photodiode wie in Anspruch 14 beschrieben.

In einem weiteren Aspekt weist ein Verfahren zur Herstellung einer integrierten schnellen CMOS-Photodiode das Herstellen eines niedrig dotierten I-Gebiets mittels Epitaxie über einem stark dotierten Substrat der gleichen Leitfähigkeitsart und das Bilden eines stark dotierten Elektrodengebiets über dem I-Gebiet auf, wobei das Elektrodengebiet invers zu dem Substrat und dem I-Gebiet dotiert ist.

Wie zuvor bereits erläutert ist, bieten die erfindungsgemäßen Verfahren die Möglichkeit, durch gut etablierte Techniken, beispielsweise die Epitaxie, das I-Gebiet in abgestimmter Weise, beispielsweise im Hinblick auf die zu detektierende Wellenlänge, herzustellen, ohne die Fertigungssequenz anderer CMOS-Bauelemente wesentlich zu beeinflussen. Andererseits kann die Herstellung der schnellen Photodiode insbesondere des entsprechenden Elektrodengebiets, das als Kathode oder Anode fungieren kann, abhängig von der Art des verwendeten dotierten Substrats, zusammen mit den Implantationsprozessen für die weiteren CMOS-Bauelemente hergestellt werden.

In einer weiteren vorteilhaften Ausführungsform wird bei der Herstellung des Elektrodengebiets eine Implantationsmaske verwendet, die einen Abstand zu einem benachbarten höher dotierten Gebiet, das insbesondere ein Wannengebiet ist, von 2,5 bis 10µm ergibt. Auf diese Weise ist eine gleichzeitige Herstellung von beispielsweise Wannengebieten oder Drain- und Sourcegebieten mit dem Elektrodengebiet möglich, wobei gleichzeitig ein ausreichend großer Abstand zur Reduzierung der gegenseitigen Beeinflussung erreicht wird.

Vorteilhafterweise ist die Implantationsmaske so gestaltet, dass das Elektrodengebiet in dem niedrig dotierten I-Gebiet vollständig umschlossen angeordnet ist.

Gemäß einem weiteren Aspekt wird ein Verfahren zur Herstellung einer in CMOS-Technologie integrierten schnellen PIN-Photodiode bereitgestellt. Hierbei besitzt die Photodiode die zuvor bereits beschriebenen Merkmale, wobei insbesondere das I-Gebiet als Epitaxieschicht mit einer Dotierungskonzentration von kleiner 1*10¹⁴ cm⁻³ hergestellt wird, wobei das Kathodengebiet voll umschlossen in diesem sehr niedrig dotierten I-Gebiet platziert wird, wobei der Abstand vom Rand des Kathodengebiets zu einem höher dotierten benachbarten Gebiet, das in einer Ausführungsform eines der höher dotierten Wannengebiete repräsentiert, zwischen 2,5 und 10µm beträgt.

Gemäß einem weiteren Aspekt der vorliegenden Erfindung wird die Aufgabe durch ein Verfahren zur Herstellung einer in CMOS-Technologie integrierten schnellen NIP-Photodiode gelöst, wobei die Photodiode aus einer dem hochdotierten n-Substrat mit einem spezifischen elektrischen Widerstand von kleiner 0,05 Ohm.cm entsprechenden Kathode, einem sich anschließenden niedrig n-dotierten I-Gebiet und einer in der Dotierung dem p⁺-dotierten Bereichen des Source und Drain oder des Wannengebiets entsprechenden p-Anode besteht. Ferner wird das niedrig dotierte I-Gebiet als Epitaxieschicht mit einer Dotierungskonzentration von kleiner 1*10¹⁴ cm⁻³ und einer Dicke zwischen 8 und 25 µm bereitgestellt, wobei das Anodengebiet voll umschlossen in diesem sehr niedrig dotierten I-Gebiet platziert wird, und wobei der Abstand vom Rand des Anodengebiets zu einem höher dotierten benachbarten Gebiet, das in einer Ausführungsform eines der höher dotierten Wannengebiete repräsentiert, zwischen 2,5 und 10µm beträgt.

Vorteilhafte Ausgestaltungen sind von den abhängigen Ansprüchen erfasst.

Die Erfindung erreicht, dass ohne besonderen Mehraufwand in der CMOS-Technologie der Frequenzbereich der PIN-Fotodioden bis 1 GHz ausgedehnt werden kann, ohne dass die normalen n- und p-MOS-Transistoren der integrierten Schaltung beeinträchtigt werden.

Die Erfindung wird nun anhand von Ausführungsbeispielen unter Zuhilfenahme der Zeichnung erläutert und ergänzt. Es zeigen:
- **Figur 1**: den Querschnitt einer integrierten PIN-Fotodiode in CMOS-Technologie in schematischer Darstellung gemäß einer anschaulichen Ausführungsform der vorliegenden Erfindung,
- **Figur 2**: die Dotierungsprofile einer konventionellen Drain-Fotodiode in CMOS-Technotogie;
- **Figur 3**: das Dotierungsprofil einer erfindungsgemäßen PIN-Drain-Fotodiode,
- **Figur 4**: das Dotierungsprofil einer erfindungsgemäßen PIN-Wannen-Fotodiode,
- **Figur 5**: die Tiefenverteilung des elektrischen Feldes im Vergleich der mit CMOS-Technologie hergestellten erfindungsgemäßen PIN-Fotodiode mit der konventionellen Fotodiode und die Tiefenverteilung der erzeugten Ladungsträger,
- **Figur 6**: das zeitliche Abklingverhalten des Fotostromes nach Ausschalten der Lichtquelle im Vergleich erfindungsgemäße PIN-Fotodiode mit konventioneller Fotodiode;
- **Figur 7**: das Frequenzverhalten im Vergleich erfindungsgemäße PIN-Fotodiode mit konventioneller Fotodiode.

Die Figuren sind an sich selbsterklärend und bedürfen keiner eingehenden Erläuterung. Dennoch soll hier kurz der Aufbau einer beispielhaften Ausführungsform einer PIN-Fotodiode erläutert werden.

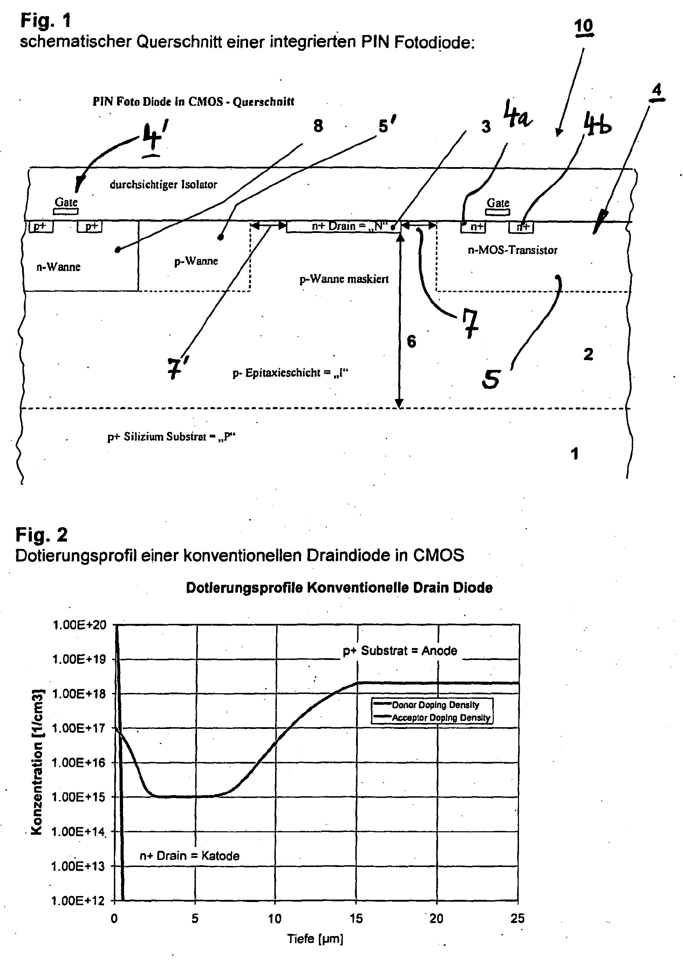

Fig. 1 zeigt ein CMOS-Bauelement 10 mit einem Substrat 1, das in dem vorliegenden Ausführungsbeispiel ein hochdotiertes p-Substrat ist und im Weiteren auch als p-Gebiet oder Anode bezeichnet wird. Ferner weist das Bauelement 10 eine Schicht 2 auf, die als sehr gering dotierte Schicht auch als I-Gebiet bezeichnet ist, wobei eine Dotierstoffkonzentration kleiner als ungefähr 1*10¹⁴ cm⁻³ betragen kann. In der vorliegenden Ausführungsform ist das I-Gebiet 2 in der gleichen Weise dotiert wie das p-Substrat 1. Ferner sind in dem Bauelement 10 in der Nähe der Substratoberfläche weitere CMOS-Bauelemente hergestellt, die beispielhaft mit 4 und 4' bezeichnet sind, wobei dieses Bauelement 4' eine entsprechende Wanne 8 bzw. das Bauelement 4 ein hoch dotiertes Drain- und Sourcegebiet 4a,4b aufweist, bspw. in Form von p- und n-Wanne und n⁺- und p⁺-Drain- und Sourcegebiet. Des weiteren ist zwischen den zwei benachbarten p-Wannen 5' und 5 das I-Gebiet 2 ausgebildet, wobei an dessen oberen Ende ein stark dotiertes Gebiet 3 angeordnet ist, das in der vorliegenden Ausführungsform als n-Gebiet bzw. als Kathode dient. In der in Fig. 1 dargestellten Ausführungsform weist das n-Gebiet 3 eine Dotierstoffkonzentration auf, die den n⁺-Dotierstoff-Konzentrationen der entsprechenden n-MOS-Transistoren in beispielsweise der p-Wanne 5 entspricht. In anderen Ausführungsformen, die in Fig. 1 nicht gezeigt sind, kann das n-Gebiet 3 eine Dotierung aufweisen, die beispielsweise der Dotierung einer n-Wanne entspricht, wie sie beispielsweise als n-Wanne 8 dargestellt ist. Ferner ist eine Dicke, die mit 6 bezeichnet ist, der Epitaxieschicht, d. h. des I-Gebiets 2, in einem Bereich von etwa 8 bis 25 µm, während ein jeweiliges Randgebiet 7,7' des n-Gebiets 3 zur jeweils benachbarten p- oder n-Wanne von anderen CMOS-Bauelementen eine Ausdehnung im Bereich von ungefähr 2,5 bis 10 µm aufweist. Somit ist das n-Gebiet oder die Kathode 3 vollständig von dem I-Gebiet 2 umschlossen.

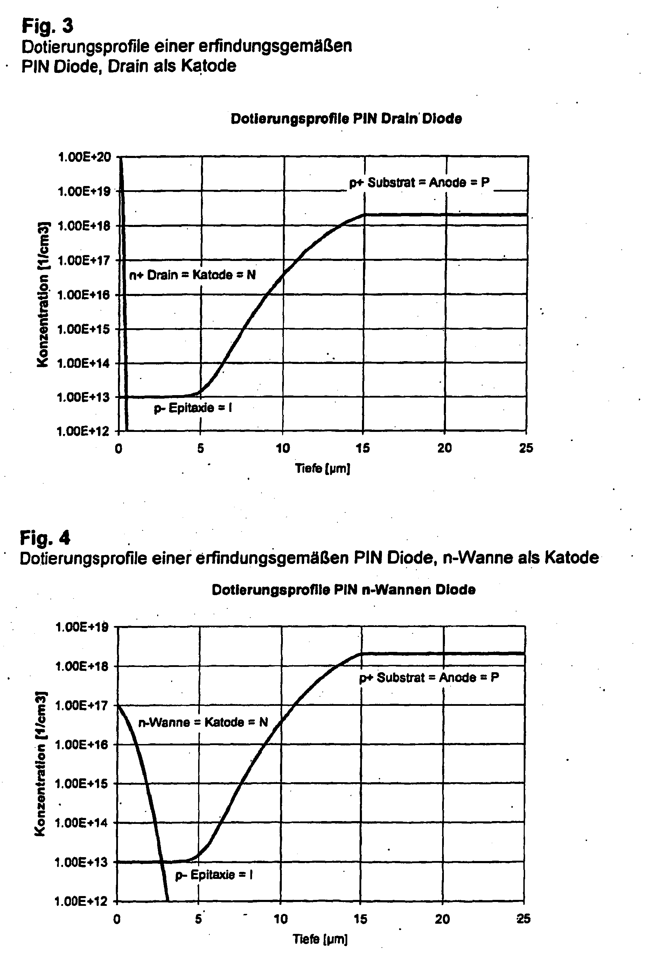

Fig. 3 zeigt eine beispielhafte Verteilung der Dotierungskonzentration, wobei ausgehend von dem Substrat, d. h. dem p-Gebiet 1, die Konzentration beginnend bei einer Tiefe von ungefähr 15 µm steil abfällt und bei einer Tiefe von etwa 7 bis 8µm eine Konzentration von 1*10¹⁴ cm⁻³ aufweist, die dann sogar noch weiter abfällt, so dass sich ein ausgeprägter Übergang beim n-Gebiet 3 bildet, wobei dieses eine der hohen Konzentration von Drain- und Sourcegebieten entsprechende Konzentration aufweist.

Fig. 4 zeigt ein entsprechendes Dotierungsprofil, wobei das n-Gebiet 3 die Dotierkonzentration und das Profil des n-Wannengebiets, beispielsweise das Gebiets 8, aufweist. Der Verlauf der Dotierstoffkonzentration in dem I-Gebiet ist im Wesentlichen identisch zu dem Verlauf in Fig. 3.

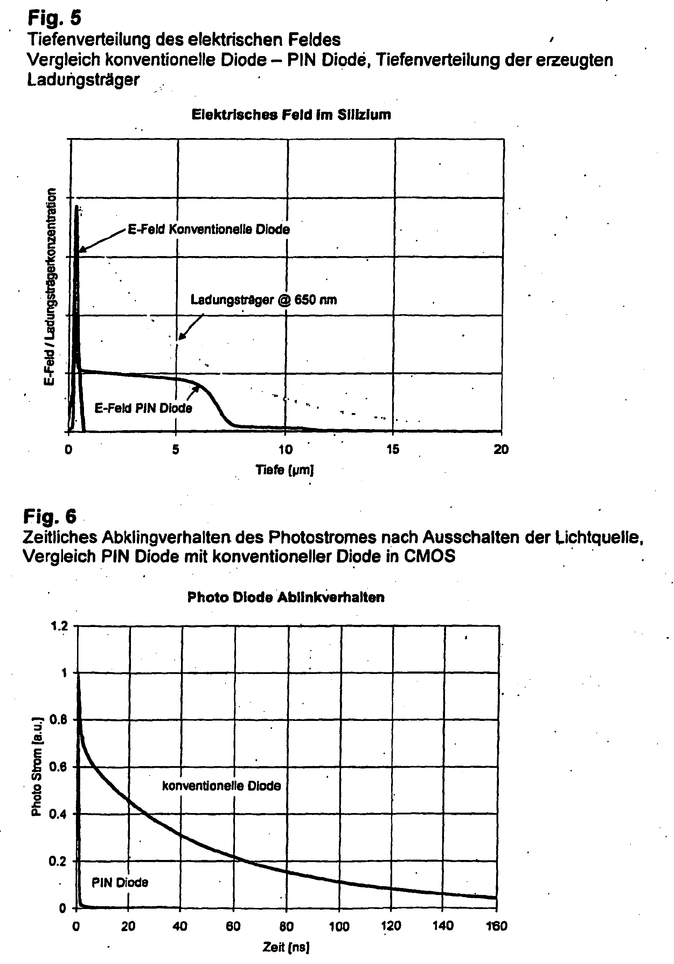

Fig. 5 zeigt eine entsprechende Tiefenverteilung des elektrischen Feldes, das durch die Anordnung PIN gemäß der vorliegenden Erfindung, insbesondere in größeren Tiefen erreicht wird, so dass eine entsprechende Ladungsträgeraufsammlung in sehr effizienter Weise erfolgen kann.

Fig. 6 zeigt das sich daraus ergebende Abklingverhalten des Photostroms gegenüber einer konventionellen Diode, so dass hier deutlich ersichtlich ist, dass wesentlich höhere Frequenzen verarbeitet werden können.

PIN-Drain-Fotodiode bedeutet, dass für die Kathode die normale n⁺-Drain-Dotierung eingesetzt ist. PIN-Wannen-Fotodiode bedeutet, dass für die Kathode die normale n-Wannendotierung eingesetzt ist.

Ausgangsbasis ist eine Twin Well CMOS-Technologie in p-Silizium, vorzugsweise p/p⁺-Epitaxiematerial Statt eines üblichen Epitaxiematerials mit 10 bis 30 Ohm.cm spezifischem elektrischen Widerstand, entsprechend etwa 5 bis 10*10¹⁴ Bor/cm³ wird erfindungsgemäß ein deutlich schwächer dotiertes Epitaxiematerial eingesetzt. Die Dotierung desselben liegt unter 1*10¹⁴ Bor/cm³ (entsprechend etwa 300 bis 1000 Ohm.cm).

Die Dicke der Epitaxieschicht 2 liegt zwischen 8 und 25 µm und sollte in Abhängigkeit von der zu detektierenden Wellenlänge gewählt werden. Unterhalb der Epitaxieschicht 2 befindet sich wie üblich stark dotiertes Silizium mit einer Dotierungskonzentration von größer 1*10¹⁸ Bor/cm³ entsprechend einem Widerstand von kleiner 0,05 Ohm.cm.

Als PIN-Fotodiode wird die Anordnung
- **P:**: stark dotiertes p-Silizium
- **I:**: schwach dotierte p-Epitaxieschicht
- **N**:: stark dotiertes n-Gebiet, entsprechend n-Source- bzw. n-Drain-Gebiet oder entsprechend mitteldotiertem n-Wannengebiet wirksam.

Zur Erhaltung des I-Charakters der mittleren Schicht, d.h., der Schicht 2, darf im Diodengebiet, d.h., das durch das N-Gebiet lateral definierte Gebiet, die p-Wanne nicht vorhanden sein. Um zu verhindern, dass in diesem Gebiet eine zusätzlich p-Dotierung erfolgt, ist dieses Gebiet entweder mit der vorhandenen p-Wannenmaske zu maskieren oder im Fall einer "selbstjustierenden p-Wanne" eine zusätzliche Maske anzuwenden. Diese Maskierung erstreckt sich vorteilhaft lateral über das aktive Fotodiodengebiet hinaus erstrecken, d.h. es zwischen dem Kathodengebiet 3 der PIN-Fotodiode und dem nächsten Wannengebiet ist vorteilhaft ein Gebiet 7 ohne zusätzliche Dotierung vorgesehen, dessen Breite zwischen 2,5 und 10 µm beträgt.

Für große Fotodioden (einige 10 µm Ausdehnung) kann die n-Schicht entweder ganzflächig homogen dotiert sein oder aber mit Unterbrechungen ausgelegt sein, dergestalt dass im räumlichen Wechsel N und I Schicht folgt mit minimalen Breiten der N Schicht und etwa 2.5 bis 10 µm Breite des I-Gebiet. Diese Anordnung erhöht für kurze Wellenlängen (blaues Licht) die Empfindlichkeit.

Die normalen n- und p-MOS-Transistoren der CMOS-Technologie werden wie bisher in p- bzw. n-Wannen platziert und sind nachgewiesenermäßen von der Änderung des Ausgangsmaterials nicht beeinträchtigt.

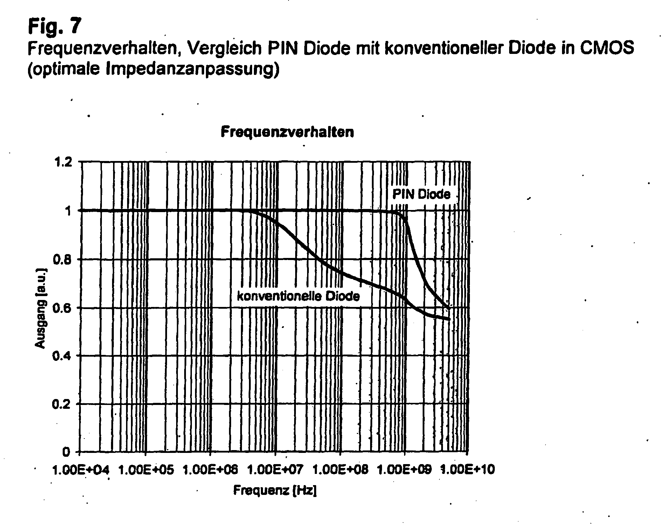

Figur 7 zeigt, dass unter herkömmlichen Bedingungen bei 10 MHz der Frequenzgang von Fotodioden in CMOS-Technologie deutlich zu degradieren beginnt. Mit der erfindungsgemäßen Konstruktion kann der Frequenzbereich bis 1 GHz ausgedehnt werden. Die Verhältnisse variieren in Abhängigkeit von der Wellenlänge und der Dicke der sehr niedrig dotierten Epitaxieschicht. Bei optimaler Wahl der Dicke geht der Frequenzgang nicht zu Lasten der Empfindlichkeit.

Auf diese Weise lassen sich mehrere schnelle Fotodioden neben normalen CMOS-Schaltungen monolithisch integrieren. Es ist allerdings zu berücksichtigen, dass die Anoden der Fotodioden, oder bei einer NIP-Struktur, die Kathoden, verbunden sind. Hauptanwendungsgebiet ist die schnelle Datenübertragung in einem oder mehreren Kanälen (kleiner 1000).

Es liegt im Rahmen der Erfindung, dass auch Fotodioden mit umgekehrter Dotierung, d.h. quasi integrierte PIN-Fotodioden als Bestandteil der CMOS-Technblogie mit verbesserten Frequenzdaten erzeugt werden können. Dementsprechend ist der Leitungstyp der verschiedenen Dotierungsgebiete, welche die Fotodiode betreffen, jeweils umgekehrt.

## Patentansprüche

1. **Integrierte Fotodiode** mit einem Substrat (1), das mit einem Dotierstoff einer ersten Leitfähigkeitsart hoch dotiert ist, um einen spezifischen Widerstand des Substrats zu erhalten, und mit
- einem sich anschließenden I-Gebiet (2), das mit einem Dotierstoff der ersten Leitfähigkeitsart niedrig dotiert ist und eine Dicke aufweist;
- einem Elektrodengebiet (3) mit einer Dotierung einer zweiten, zur ersten inversen Leitfähigkeitsart, wobei die Dotierung in ihrer Höhe einem in dem Substrat gebildeten Wannengebiet (8) oder einem Source und Drain eines in dem Substrat gebildeten CMOS-Bauelements (4) entspricht,
**dadurch gekennzeichnet, dass**
- der spezifische Widerstand des Substrats (1) kleiner 50mOhm*cm ist und die Dicke des I-Gebietes (2) zwischen 8µm und 25µm ist.

2. Integrierte Fotodiode nach Anspruch 1, wobei das niedrig dotierte I-Gebiet eine Dotierungskonzentration von kleiner als 10¹⁴ cm⁻³ aufweist.

3. Integrierte Fotodiode nach Anspruch 1, wobei diese mit mehreren baugleichen Fotodioden mit Auswerteschaltungen für mehrere Kanäle integriert ist.

4. Integrierte Fotodiode nach einem der Ansprüche 1 bis 3, wobei das Elektrodengebiet (3) voll umschlossen in dem niedrig dotierten I-Gebiet liegt.

5. Integrierte Fotodiode nach einem der Ansprüche 1 bis 4, wobei der Abstand (7,7') vom Rand des Elektrodengebietes (3) zu einem benachbarten Wannengebiet (5,5') zwischen 2,5µm und 10µm beträgt.

6. Integrierte Fotodiode nach einem der Ansprüche 1 bis 5, wobei das Substrat p-dotiert ist und den spezifischen elektrischen Widerstand von kleiner als 50 mOhm*cm aufweist.

7. Integrierte Fotodiode nach einem der Ansprüche 1 bis 5, wobei das Substrat (1) n-dotiert ist.

8. Integrierte Fotodiode nach Anspruch 1, wobei die Dotierung des Elektrodengebiets (3) in oder nach Typ, Höhe und Verlauf der Dotierung des Wannengebiets (8) entspricht.

9. Integrierte Fotodiode nach Anspruch 1, wobei die Dotierung des Elektrodengebiets in Typ, Höhe und Verlauf der Dotierung von Drain und Source eines in dem Substrat hergestellten CMOS-Bauelements (4) entspricht.

10. Integrierte Fotodiode nach einem der Ansprüche 1 bis 9, wobei das I-Gebiet (2) als Epitaxieschicht hergestellt ist.

11. Integrierte Fotodiode nach einem der Ansprüche 1 bis 10, wobei die Dicke des I-Gebietes in Abhängigkeit von der Wellenlänge bestimmt ist.

12. Integrierte Fotodiode nach einem der Ansprüche 1 bis 11, wobei die Fotodiode als Detektor mit Auswerteschaltungen integriert ist.

13. Integrierte Fotodiode nach einem der Ansprüche 1 bis 11, wobei diese als Detektor mit Transimpedanz-Verstärkern in Auswerteschaltungen integriert ist.

14. **Verfahren zur Herstellung** einer integrierten schnellen Fotodiode, mit
- Herstellen eines niedrig dotierten I-Gebiets mit einer Dicke von 8µm bis 25µm über einem stark dotierten Substrat (1) der gleichen Leitfähigkeitsart mit einem spezifischen Widerstand von kleiner als 50mOhm*cm;
- Bilden eines Elektrodengebiets (3) über dem I-Gebiet (2) zusammen mit einem Wannen-Bauelement (4,4'), wobei das Elektrodengebiet invers zu dem Substrat und dem I-Gebiet dotiert wird oder ein Drain- und Sourcegebiet (4a,4b) eines CMOS-Bauelements (4) dotiert wird.

15. Verfahren nach Anspruch 14, wobei das I-Gebiet (2) durch einen Epitaxieprozess gebildet wird.

16. Verfahren nach Anspruch 14, wobei das Elektrodengebiet (3) zusammen mit einem Wannengebiet oder einem Drain- und Sourcegebiet des CMOS-Bauelements (4) hergestellt wird.

17. Verfahren nach einem der Ansprüche 14 bis 16, wobei bei der Herstellung des Elektrodengebiets (3) eine Implantationsmaske verwendet wird, die einen Abstand zum nächsten höher dotierten Gebiet von 2,5 bis 10µm ergibt.

18. Verfahren nach Anspruch 17, wobei die Implantationsmaske so gestaltet ist, dass das Elektrodengebiet (3) voll umschlossen in dem niedrig dotierten I-Gebiet (2) platziert wird.

19. Verfahren nach einem der Ansprüche 14 bis 18, wobei das Substrat (1) ein p-Substrat ist mit dem spezifischen elektrischen Widerstand von kleiner 0,05 Ohm*cm und als weitere Elektrode dient, wobei das niedrig dotierte I-Gebiet (2) mit einer Dotierungskonzentration von kleiner 10¹⁴ cm⁻³ und mit der Dicke zwischen 8 und 25 µm hergestellt wird.

## Claims

1. Integrated photodiode having a substrate (1), which is highly doped with a doping material of a first conductivity type in order to obtain a specific resistance of the substrate, and having
- a connecting I zone (2) which is low doped with a doping material of the first conductivity type and has a thickness;
- an electrode zone (3) having doping of a second conductivity type which is inverse to the first, wherein doping as regards its height corresponds to a trough zone (8) formed in the substrate or to a source and drain of a CMOS component (4) formed in the substrate,
**characterised in that**
- the specific resistance of the substrate (1) is less than 50 mohm*cm and the thickness of the I zone (2) is between 8 µm and 25 µm.

2. Integrated photodiode according to claim 1, wherein the low-doped I zone has a doping concentration of less than 10¹⁴ cm⁻³.

3. Integrated photodiode according to claim 1, wherein the latter is integrated with several similar photodiodes having evaluating circuits for several channels.

4. Integrated photodiode according to one of claims 1 to 3, wherein the electrode zone (3) lies completely enclosed in the low-doped I zone.

5. Integrated photodiode according to one of claims 1 to 4, wherein the distance (7, 7') from the edge of the electrode zone (3) to an adjacent trough zone (5, 5') is between 2.5 µm and 10 µm.

6. Integrated photodiode according to one of claims 1 to 5, wherein the substrate is p-doped and has the specific electrical resistance of less than 50 mOhm*cm.

7. Integrated photodiode according to one of claims 1 to 5, wherein the substrate (1) is n-doped.

8. Integrated photodiode according to claim 1, wherein doping of the electrode zone (3) corresponds in or according to type, height and path to doping of the trough zone (8).

9. Integrated photodiode according to claim 1, wherein doping of the electrode zone (3) corresponds in type, height and path to doping of drain and source of a CMOS component (4) produced in the substrate.

10. Integrated photodiode according to one of claims 1 to 9, wherein the I zone (2) is produced as an epitaxial layer.

11. Integrated photodiode according to one of claims 1 to 10, wherein the thickness of the I zone is determined as a function of the wavelength.

12. Integrated photodiode according to one of claims 1 to 11, wherein the photodiode is integrated as a detector having evaluating circuits.

13. Integrated photodiode according to one of claims 1 to 11, wherein the latter is integrated as a detector having transimpedance amplifiers in evaluating circuits.

14. Process for producing an integrated high-speed photodiode, with
- production of a low-doped I zone having a thickness of 8 µm to 25 µm above a strongly doped substrate (1) of the same conductivity type having a specific resistance of less than 50 mOhm*cm;
- forming an electrode zone (3) above the I zone (2) together with a trough component (4, 4'), wherein the electrode zone is doped inversely to the substrate and the I zone or a drain and source zone (4a, 4b) of a CMOS component (4) is doped.

15. Process according to claim 14, wherein the I zone (2) is formed by an epitaxial process.

16. Process according to claim 14, wherein the electrode zone (3) is produced together with a trough zone or a drain and source zone of the CMOS component (4).

17. Process according to one of claims 14 to 16, wherein in the production of the electrode zone (3), an implantation mask is used which produces a distance from the next higher doped zone of 2.5 to 10 µm.

18. Process according to claim 17, wherein the implantation mask is designed so that the electrode zone (3) is placed completely enclosed in the low-doped I zone (2).

19. Process according to one of claims 14 to 18, wherein the substrate (1) is a p-substrate having the specific electrical resistance of less than 0.05 Ohm*cm and serves as a further electrode, wherein the low-doped I zone (2) is produced with a doping concentration of less than 10¹⁴ cm⁻³ and having a thickness between 8 and 25 µm.

## Revendications

1. Photodiode intégrée avec un substrat (1), qui est fortement dopé par une substance de dopage d'un premier type de conductivité, pour obtenir une résistance spécifique du substrat, et avec
- une zone I adjacente (2) qui est faiblement dopée par une substance de dopage du premier type de conductivité et présente une certaine épaisseur ;
- une zone d'électrode (3) avec un dopage d'un second type de conductivité inverse du premier, le niveau dudit dopage correspondant à une zone en auge (8) formée dans le substrat ou à une source et à un drain d'un composant CMOS (4) formé dans le substrat, **caractérisé en ce que**
- la résistance spécifique du substrat (1) est inférieure à 50 mohms*cm et l'épaisseur de la zone I (2) est comprise entre 8 µm et 25 µm.

2. Photodiode intégrée selon la revendication 1, dans laquelle la zone I faiblement dopée présente une concentration de dopage inférieure à 10¹⁴ cm⁻³.

3. Photodiode intégrée selon la revendication 1, qui est intégrée avec plusieurs photodiodes de structure identique avec des circuits d'évaluation pour plusieurs canaux.

4. Photodiode intégrée selon l'une quelconque des revendications 1 à 3, dans laquelle la zone d'électrode (3) est entièrement enclavée dans la zone I faiblement dopée.

5. Photodiode intégrée selon l'une quelconque des revendications 1 à 4, dans laquelle l'espacement (7, 7') entre le bord de la zone d'électrode (3) et la zone en auge adjacente (5, 5') est comprise entre 2,5 µm et 10 µm.

6. Photodiode intégrée selon l'une quelconque des revendications 1 à 5, dans laquelle le substrat possède un dopage de type p et présente une résistance électrique spécifique inférieure à 50 mOhms*cm.

7. Photodiode intégrée selon l'une quelconque des revendications 1 à 5, dans laquelle le substrat (1) possède un dopage de type n.

8. Photodiode intégrée selon la revendication 1, dans laquelle le dopage de la zone d'électrode (3) correspond au dopage de la zone en auge (8) de par ou selon son type, son niveau et son profil.

9. Photodiode intégrée selon la revendication 1, dans laquelle le dopage de la zone d'électrode correspond au dopage du drain et de la source d'un composant CMOS (4) fabriqué dans le substrat, de par son type, son niveau et son profil.

10. Photodiode intégrée selon l'une quelconque des revendications 1 à 9, dans laquelle la zone I (2) est fabriquée sous la forme d'une couche épitaxiale.

11. Photodiode intégrée selon l'une quelconque des revendications 1 à 10, dans laquelle l'épaisseur de la zone I est déterminée en fonction de la longueur d'onde.

12. Photodiode intégrée selon l'une quelconque des revendications 1 à 11, dans laquelle la photodiode est intégrée sous la forme d'un détecteur avec des circuits d'évaluation.

13. Photodiode intégrée selon l'une quelconque des revendications 1 à 11, qui est intégrée à des circuits d'évaluation sous la forme d'un détecteur avec des amplificateurs de transimpédance.

14. Procédé de fabrication d'une photodiode rapide intégrée, consistant à :
- fabriquer une zone I faiblement dopée ayant une épaisseur de 8 µm à 25 µm sur un substrat fortement dopé (1) du même type de conductivité avec une résistance spécifique inférieure à 50 mOhms*cm ; et
- former une zone d'électrodes (3) au-dessus de la zone I (2) conjointement avec un composant en auge (4, 4'), dans lequel la zone d'électrode est dopée à l'inverse du substrat et de la zone I ou une zone de drain et de source (4a, 4b) d'un composant CMOS (4) est dopée.

15. Procédé selon la revendication 14, dans lequel la zone I (2) est formée par un processus épitaxial.

16. Procédé selon la revendication 14, dans lequel on fabrique la zone d'électrode (3) conjointement avec une zone en auge ou une zone de drain et de source du composant CMOS (4).

17. Procédé selon l'une quelconque des revendications 14 à 16, dans lequel on utilise, lors de la fabrication de la zone d'électrode (3), un masque d'implantation qui établit un espacement de 2,5 à 10 µm par rapport à la zone suivante plus fortement dopée.

18. Procédé selon la revendication 17, dans lequel le masque d'implantation est conçu de sorte que la zone d'électrode (3) soit complètement enclavée dans la zone I faiblement dopée (2).

19. Procédé selon l'une quelconque des revendications 14 à 18, dans lequel le substrat (1) est un substrat de type p avec une résistance électrique spécifique inférieure à 0,05 Ohm*cm et sert d'autre électrode, la zone I faiblement dopée (2) étant fabriquée avec une concentration de dopage inférieure à 10¹⁴ cm⁻³ et avec une épaisseur comprise entre 8 et 25 µm.
